**Europäisches Patentamt**

**European Patent Office**

**Office européen des brevets**

(19)

(11) Veröffentlichungsnummer : **0 409 177 B1**

(12)

# EUROPÄISCHE PATENTSCHRIFT

(45) Veröffentlichungstag der Patentschrift :
**05.10.94 Patentblatt 94/40**

(51) Int. Cl.$^5$ : **H01S 3/00, H01S 3/085, H01S 3/103, H04B 10/16**

(21) Anmeldenummer : **90113695.2**

(22) Anmeldetag : **17.07.90**

(54) **Optisch gegengekoppelter Verstärker.**

(30) Priorität : **17.07.89 DE 3923628**

(43) Veröffentlichungstag der Anmeldung :
**23.01.91 Patentblatt 91/04**

(45) Bekanntmachung des Hinweises auf die
Patenterteilung :
**05.10.94 Patentblatt 94/40**

(84) Benannte Vertragsstaaten :
**DE FR GB IT**

(56) Entgegenhaltungen :
**EP-A- 0 245 085**
**EP-A- 0 285 393**
**EP-A- 0 300 790**
**EP-A- 0 316 194**

(56) Entgegenhaltungen :
**CONFERENCE DIGEST OF THE 11TH IEEE
INTERNATIONAL SEMICONDUCTOR LASER
CONFERENCE, Boston, MA, 29. August - 1.
September 1988, Seiten 124-125; K. KONDO et
al : "A tunable optical-wavelength conversion
laser with TM-polarizedlight input"
ELECTRONICS LETTERS, Band 24, Nr. 25, 8.
Dezember 1988, Seiten 1537-1539,Stevenage,
Herts, GB; T.J. WHITLEY: "Laser diode pumped operation of Er3+-dopedfibre amplifier"**

(73) Patentinhaber : **SIEMENS
AKTIENGESELLSCHAFT
Wittelsbacherplatz 2
D-80333 München (DE)**

(72) Erfinder : **Schimpe, Robert, Dr.-Ing
Georg-Kerschenst.-Strasse 56
D-8012 Ottobrunn-Riemerling (DE)**

**Beschreibung**

Die vorliegende Erfindung betrifft die Anordnung eines DFB-Lasers als optisch gegengekoppelter Verstärker.

Eine Anordnung, bei der durch optische Einstrahlung in einen DFB-Laser eine (positive) Rückkopplung erzielt wird, ist in der Veröffentlichung von H. Kawaguchi: "Tunable Optical Wavelength Coversion Using an Optically Triggerable Multielectrode Distributed Feedback Laser Diode" in IEEE Journal of Quantum Electronics 24, 2153-2159 (1988) beschrieben. In dieser Veröffentlichung wird ein DFB-Laser mit einem sättigbaren Absorber beschrieben, durch den bewirkt wird, daß der unterhalb der Laserschwelle betriebene DFB-Laser durch eingestrahltes Licht aktiviert werden kann. Außerdem ist diese Vorrichtung für die Wellenlängenabstimmung vorgesehen.

In der EP 0 174 729 ist ein Verfahren zum Verstärken eines optischen Signals beschrieben, das aufweist Einkoppeln des zu verstärkenden optischen Signals in die aktive Schicht einer Halbleiterlaserstruktur, durch die ein Treiberstrom fließt, wobei das verstärkte Signal von der aktiven Schicht emittiert wird und wobei in dem Verfahren die Wellenlänge $\lambda_M$ des Verstärkungsmaximums bei diesem Treiberstrom für die untere Leistungsgrenze der optischen Eingangsleistung, die längere $\lambda_{Upper}$ der zwei Wellenlängen bei Nullverstärkung bei dem Treiberstrom für die untere Leistungsgrenze der optischen Eingangsleistung und die Wellenlänge $\lambda$ des zu verstärkenden optischen Signales verknüpft sind durch die folgende Beziehung:

$\lambda_{Upper}$ größer $\lambda$ größer $\lambda_M$.

Eine Anordnung, bei der durch optische Einstrahlung in einen Halbleiterlaser eine konstante optische Verstärkung erzielt wird, ist in der Veröffentlichung von W. F. Kosonocky et al.: "GaAs Amplifiers" in IEEE Journal of Quantum Electronics 4, 125-131 (1986) beschrieben. In dieser Veröffentlichung wird ein Halbleiterlaser mit Fabry-Perot-Resonator beschrieben, in den das zu verstärkende Licht senkrecht zur Ausbreitungsrichtung des Laserlichts eingestrahlt wird.

Aufgabe der vorliegenden Erfindung ist es, eine Anordnung mit einem Halbleiterlaser anzugeben, mit der unter anderem auf einfache Weise eine konstante optische Verstärkung erreicht werden kann.

Diese Aufgabe wird mit einer Anordnung nach Anspruch 1 gelöst. Die Ansprüche 2 bis 9 und 20 geben besonders vorteilhafte Ausgestaltungen an. Die Ansprüche 10 bis 17 geben besonders bevorzugte Anwendungen dieser Anordnung an. Die Ansprüche 18 und 19 betreffen Anordnungen mit mindestens einem Paar von Wellenlängenumsetzern, von denen mindestens ein Wellenlängenumsetzer eine Anordnung nach Anspruch 1 ist.

Es folgt eine Beschreibung der Erfindung anhand der Fig. 1 bis 8.

Fig. 1     zeigt die erfindungsgemäße Anordnung im Längsschnitt.

Fig. 2     zeigt den Schwellengewinn Gt des Resonators, den Gewinn Gm des Verstärkungsmediums und dem Gewinn Ga des absorbierenden Mediums im Laserbetrieb, aufgetragen über der Wellenlänge.

Fig. 3     zeigt die Strahlungsleistung des Lasers, aufgetragen über der Leistung des eingestrahlten Lichtes mit dem Betriebsstrom als Parameter.

Fig. 4     zeigt die erfindungsgemäße Anordnung in der Funktion eines Faserverstärkers.

Fig. 5     zeigt eine Alternative zu der Anordnung von Fig. 4.

Fig. 6     zeigt eine erfindungsgemäße Anordnung als Teil eines OEIC.

Fig. 7     zeigt ein besonders vorteilhaftes Ausführungsbeispiel im Querschnitt.

Fig. 8     zeigt das Blockschaltbild eines Wellenlängenschalters unter Verwendung der vorliegenden Erfindung.

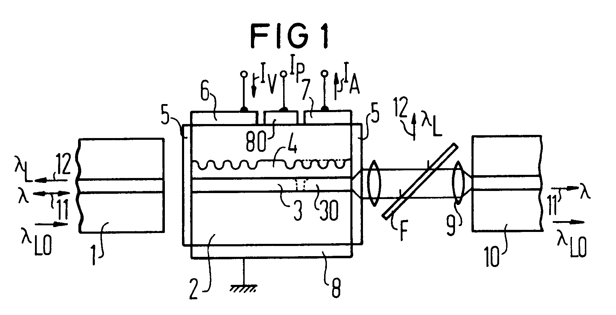

Es folgt eine Beschreibung der Erfindung anhand der Fig. 1. Die erfindungsgemäße Anordnung besteht aus einem Halbleiterlaser 2 mit mindestens einem (fakultativ abstimmbaren) schmalbandigen Wellenlängenfilter und mit mindestens einem optischen Verstärkungsmedium, so daß die Erzeugung von Laserstrahlung bei einer selektierten Wellenlänge $\lambda_L$ ermöglicht wird. Diese selektierte Wellenlänge $\lambda_L$ ist vorzugsweise verschieden von der Wellenlänge $\lambda_M$ maximalen Gewinns des Verstärkungsmediums bei Laserbetrieb, im folgenden ausgezeichnete Wellenlänge $\lambda_M$ genannt. Das Wellenlängenfilter kann beispielsweise ein Wellenleiter-Bragg-Reflektor, evtl. mit phasenverschobenen Gittern 4 oder mit elektronisch abstimmbarer Phasenschieberzone sein. Die Bandbreite $\Delta\lambda$ beispielsweise eines Bragg-Reflektors beträgt

$$\Delta\lambda = \lambda_L^2 K/( \pi \, n_g R^{\frac{1}{2}}),$$

wobei R die zugelassene Intensitätsrestreflexion des Filters außerhalb der Bandbreite des Filters, $\lambda_L$ eine bereits definierte selektierte Wellenlänge, K der Koppelfaktor des Bragg-Reflektor-Gitters für 180°-Reflexion des Gitters und $n_g$ der effektive Gruppenbrechungsindex des Wellenleiters ist.

Da die Intensitätsrestreflexion R höchstens gleich 1 werden kann, ist $\Delta\lambda$ mindestens gleich dem Stoppband $\Delta\lambda_S = \lambda_L^2 K/(\pi \, n_g)$ des Wellenleiter-Bragg-Reflektors. Um mit der Wellenlänge einen großen Bereich überstreichen zu können, sollte der Koppelfaktor möglichst klein sein. Beispielsweise ergibt sich für den Koppelfaktor

K=10cm$^{-1}$, die Wellenlänge $\lambda_L$=1550nm und den effektiven Gruppenbrechungsindex $n_g$ =4 eine Stoppband-breite $\Delta\lambda_S$=0.19nm. Fordert man eine Intensitätsrestreflexion R < 1%, so sollte das eingestrahlte Licht einen etwa 2nm breiten Wellenlängenbereich $\Delta\lambda$ um die Laserwellenlänge $\lambda_L$ meiden. Kennzeichnend für optische Einstrahlung innerhalb dieses Wellenlängenbereichs wäre, daß aufgrund von Resonanzeffekten im Wellen-längenfilter die Wellenlänge $\lambda$ auf Bruchteile eines Nanometers genau gewählt werden muß. Bei entsprechen-der Wahl der Wellenlänge $\lambda$ kann sogar Reflexion anstatt Tranmission des eingestrahlten Lichts auftreten. Au-ßerhalb dieses Wellenlängenbereichs $\Delta\lambda$ ist die Wellenlänge $\lambda$ frei wählbar, wobei allerdings Wellenlängen $\lambda$ nahe der ausgezeichneten Wellenlänge $\lambda_M$ besonders vorteilhaft sind.

Aufgrund von Entspiegelungsschichten 5 kann Strahlung 11 mit einer Wellenlänge $\lambda$ außerhalb der ange-gebenen Bandbreite $\Delta\lambda$ des Wellenlängenfilters weitgehend ungehindert durch den Resonator hindurchtreten. Ein Teil des eingestrahlten Lichts 11 kann auch aus dem Resonator verstärkt rückreflektiert werden. Das optische Verstärkungsmedium besteht beispielsweise aus einer AlGaAs- oder InGaAsP-Doppelheterostruktur mit pn-Übergang. Die optische Wellenführung parallel zu den Halbleiterschichten kann beispielsweise durch eine MCRW-Struktur (metal clad ridge waveguide) oder BH-Struktur (buried hetero) erfolgen. Das Verstärkungsmedium kann auch Potentialtöpfe enthalten. Zur Erzeugung der optischen Verstärkung wird die Dichte der elektrischen Träger im Verstärkungsmedium erhöht, beispielsweise durch Injektion eines Stromes $I_v$ in Flußpolung des pn-Übergangs oder durch optisches Pumpen.

Zu der Anordnung gehört weiterhin eine Vorrichtung zur optischen Einstrahlung in das Verstärkungsmedium, das z.B. in dem Halbleiterlaser 2 als Wellenleiterschicht 3 ausgebildet sein kann, und zur Auskopplung der verstärkten Strahlung. Die Wellenlänge $\lambda$ der eingestrahlten Strahlung 11 liegt vorzuweise nahe der aus-gezeichneten Wellenlänge $\lambda_M$ und vorzugsweise außerhalb der oben angegebenen Bandbreite $\Delta\lambda$ des Wel-lenlängenfilters. Die Vorrichtung zum Ein- und Auskoppeln der Strahlung 11 kann z.B. in einem Faserleiter 1, 10 und ggfs. für das Auskoppeln der Strahlung aus dem Halbleiterlaser 2 einem zwischen Linsen 9 angeordneten Filter F bestehen. Dieser Filter reflektiert die Laserstrahlung 12 senkrecht aus dem Strahlengang und läßt die eingekoppelte Strahlung 11 durch.

In einer alternativen Ausführungsform kann in dem Halbleiterlaser 2 ein optisch sättigbarer Absorber, gepumpt vorzugsweise durch Strahlung bei der selektierten Wellenlänge $\lambda_L$, eingebaut sein. Der Aufbau in Fig. 1 wäre dann durch die mit gestrichelten Linien eingezeichnete Umrandung gegeben, d.h. in der Ebene der Wellenleiterschicht 3 wäre der Absorber durch eine getrennte Schicht 30 aus dem Material des Absorbers ausgebildet. Wie gezeigt, kann das Gitter 4 auch nur in einem Bereich oberhalb des Verstärkungsmediums ausgebildet sein. In der Fig. 1 sind die zugehörigen Elektroden, d.h. eine erste Elektrode 6 für den Betriebsstrom $I_V$, eine zweite Elektrode 7 für den Absorberstrom $I_A$ und eine gemeinsame dritte Elektrode 8 eingezeichnet. Fakultativ ist noch eine vierte Elektrode 20 für einen Phasenschieberstrom $I_p$ gezeichnet. Das Medium mit sättigbarer Absorption besteht beispielsweise aus einer AlGaAs-oder InGaAsP-Doppelheterostruktur mit pn-Übergang. Das absorbierende Medium kann auch Potentialtöpfe enthalten.

Zur Erhöhung der Absorption kann der pn-Übergang in Rückwärtsrichtung gepolt werden. Bei Lichteinstrahlung kann dann ein Strom $I_A$ fließen. Je nach Anwendungsziel kann die elektronische Energiebandlücke $E_A$ des absorbierenden Mediums gleich oder verschieden sein von der elektronischen Bandlücke $E_V$ des Verstärkungsmediums. Das absorbierende Medium befindet sich vorzugsweise innerhalb des Resonators.

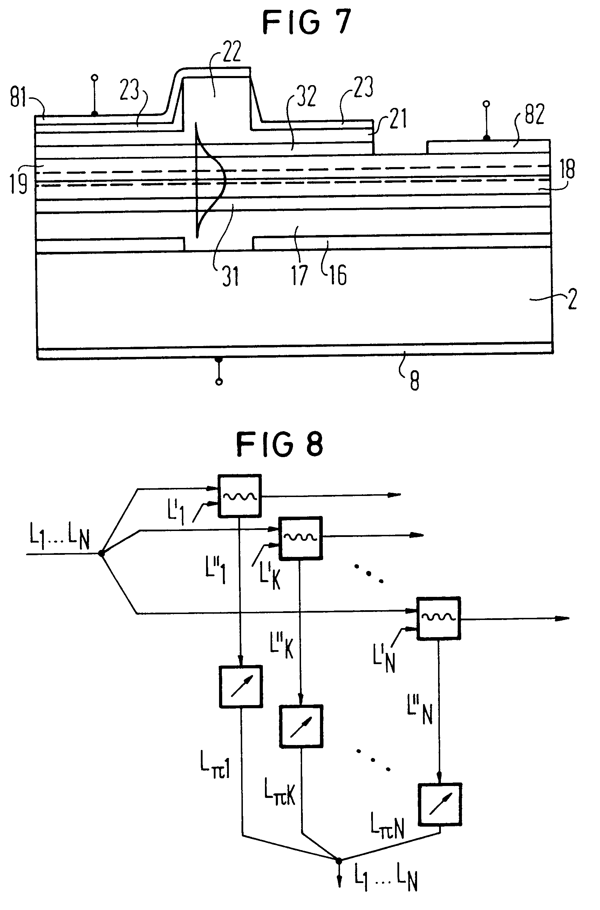

Fig. 7 zeigt eine besonders vorteilhafte alternative Ausführungsform im Querschnitt. Dabei ist der sättigbare Absorber durch die Schicht 31 gegeben. Über dieser Schicht 31 befinden sich zwei Gitterschichten 18, 19 zur Ausbildung des Bragg-Gitters. Die obersten bzw. untersten Verläufe der Grenzfläche zwischen diesen Gitterschichten 18, 19 sind durch die gestrichelten Linien eingezeichnet. Die für die Erzeugung von Laserstrahlung vorgesehene verstärkende Schicht ist als Wellenleiterschicht 32 auf diesen Gitterschichten 18, 19 angeordnet. Diese Wellenleiterschicht 32 ist lateral begrenzt. In dem von der Wellenleiterschicht 32 nicht bedeckten Bereich ist seitlich der Wellenleiterschicht 32 ein Kontakt 82 auf die oberste Gitterschicht 19 aufgebracht. Die vertikale Begrenzung der Wellenleiterschicht 32 erfolgt durch die Deckschicht 21, in deren Mitte eine Mesa 22 ausgebildet ist. Die zu dieser Mesa 22 seitlich liegenden Bereiche der Oberfläche der Deckschicht 21 sind mit einer Oxidschicht 23 isoliert. Auf der Oxidschicht ist ein Kontakt 81 aufgebracht. Die Oxidschicht 23 zusammen mit diesem Kontakt 81 dient der seitlichen Begrenzung der Laserstrahlung auf einen Bereich, der im wesentlichen unterhalb der Mesa 22 liegt, entsprechend dem MCRW-Prinzip. Der über den Substratkontakt 8 injizierte Strom wird durch eine Sperrschicht 16, die in einer Pufferschicht 17 eingebaut ist, auf den Bereich unterhalb der Mesa 22 begrenzt.

Die Gitterschichten 18, 19 wirken sowohl als optische Koppelschichten als auch als elektrische Leiterschichten für den gemeinsamen Massekontakt für das verstärkende Medium (Wellenleiterschicht 32) und das absorbierende Medium (Schicht 31). In der gezeigten Anordnung sind die koppelnden Schichten n-dotiert. Sowohl das verstärkende Medium als auch das absorbierende Medium kann Potentialtöpfe enthalten. Bei dieser Anordnung kann auf eine vierte Elektrode für einen Phasenschieberstrom verzichtet werden. In dem vorliegenden Ausführungsbeispiel kann das Substrat z. B. $p^+$-InP sein, die Sperrschicht 16 $n^+$-InP, die Pufferschicht 17 p-InP, die Schicht 31 1,6 $\mu$m-InGaAsP, die untere Gitterschicht 18 n-1,3 $\mu$m-InGaAsP, die obere Gitterschicht 19 $n^+$-InP, die Wellenleiterschicht 32 n-1,5 $\mu$m-InGaAsP und die Deckschicht 21 p-InP.

S. Mukai et al.: "Coupled parallel waveguide semiconductor laser", Appl. Phys. Lett. 44, 1984, pp. 478-480 beschreibt einen Halbleiterlaser mit zwei optisch gekoppelten und elektrisch getrennt ansteuerbaren Verstärungsschichten. Im Gegensatz zur Arbeit von Mukai weist die Struktur in Fig. 7 ein Bragg-Filter auf und verwendet unterschiedliche Materialien für die verstärkende und die absorbierende Schicht.

M.-C. Amann et al.: "Tuning Range and Threshold Current of the Tunable Twin Guide (TTG) laser", IEEE Photon. Technol. Lett., 1989, pp. 253-254 beschreibt einen Halbleiterlaser mit einer Verstärkungsschicht und einer Abstimmschicht, die optisch gekoppelt und elektrisch getrennt ansteuerbar sind. Im Gegensatz zur Arbeit von Amann wird erfindungsgemäß anstelle der Abstimmschicht z. B. eine absorbierende Schicht verwendet, die durch die Laserstrahlung gepumpt werden kann.

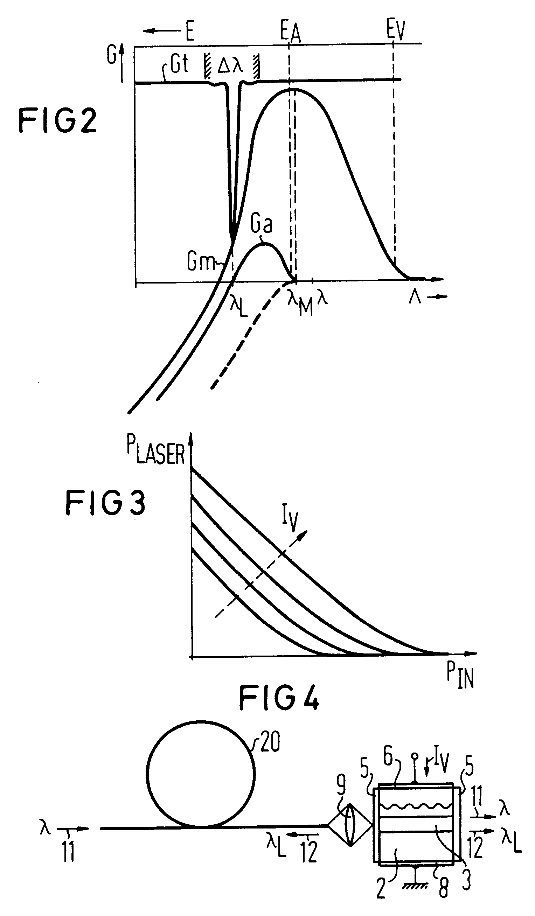

Fig. 2 zeigt ein Diagramm mit dem Schwellengewinn Gt des Resonators, dem Gewinn Gm des Verstärkungsmediums im Laserbetrieb und dem (im wesentlichen negativen) Gewinn Ga des absorbierenden Mediums, aufgetragen über der Wellenlänge. Ebenfalls gezeigt sind die elektronischen Bandlücken $E_V$ und $E_A$ des verstärkenden bzw. absorbierenden Mediums. Bei der Wellenlänge $\lambda_M$ ist der Gewinn Gm des Verstärkungsmediums maximal. Die selektierte Wellenlänge $\lambda_L$ ist durch das eingebaute Wellenlängenfilter bestimmt. Die Ausgestaltung bzw. Bemessung dieses Wellenlängenfilters, z.B. eines Gitters 4, muß so gewählt sein, daß die Differenz zwischen dem Schwellengewinn Gt des Resonators und dem Gewinn Gm des Verstärkungsmediums bei der Wellenlänge $\lambda_L$ kleiner ist als bei der Wellenlänge $\lambda_M$. Damit wird erreicht, daß bei Erhöhung des Betriebsstromes $I_V$ die Kurve des Gewinns Gm des Verstärkungsmediums die in Fig. 2 angegebene Lage einnimmt. Der Halbleiterlaser 2 strahlt dann bei der Wellenlänge $\lambda_L$. Da sich das Maximum der Kurve des Gewinns Gm des Verstärkungsmediums an der Stelle $\lambda_M$ unterhalb des Schwellengewinnes Gt des Resonators befindet, strahlt der Halbleiterlaser 2 nicht mit dieser ausgezeichneten Wellenlänge $\lambda_M$, bei der er ohne das Wellenlängenfilter anschwingen würde. Ein ausreichend niedriges Minimum der Kurve des Schwellengewinns Gt des Resonators im Punkt $\lambda_L$ erreicht man durch eine entsprechende Ausgestaltung des Wellenlängenfilters. Ein Gitter 4 muß zu diesem Zweck einen niedrigen Koppelgrad und eine große Länge aufweisen. Das genannte Bragg-Gitter mit K=10cm$^{-1}$ Koppelwirkungsgrad sollte deshalb wenigstens etwa 1000 $\mu$m Länge aufweisen.

Fig. 3 zeigt die Abhängigkeit der Intensität der Laserstrahlung von der Intensität der eingestrahlten Strahlung in Abhängigkeit von dem Betriebsstrom $I_V$. Wenn der Betriebsstrom $I_V$, der für das elektrische Pumpen sorgt, größer wird, verschiebt sich die Kurve in Pfeilrichtung.

Durch die Einstrahlung bei der Wellenlänge $\lambda$ hohen optischen Gewinns des Verstärkungmediums, d.h. $\lambda$ in der Nähe der ausgezeichneten Wellenlänge $\lambda_M$, entsteht eine hohe optische Strahlungsleistung $P_{IN}$ im aktiven Medium. Mit zunehmender optischer Strahlungsleistung $P_{IN}$ bei der Wellenlänge $\lambda$ sinkt die Zahl der verfügbaren elektrischen Träger, so daß die Laserleistung $P_{LASER}$ bei der Wellenlänge $\lambda_L$ entsprechend abnimmt. Fig. 3 zeigt die optische Kontrolle der Laseremission eines InGaAsP-DFB-Lasers bei der Wellenlänge $\lambda_L$ gleich 1280 nm. Durch Einstrahlung eines Bruchteils der Intensität der Laserleistung bei der Wellenlänge $\lambda$= 1300 nm des Maximums des optischen Gewinns im Laserbetrieb kann die Laseremission bei der Wellenlänge $\lambda_L$ abgeschaltet werden. Dabei wird der optische Gewinn in einem relativ weiten Wellenlängenbereich um die Wellenlänge $\lambda_L$ der Laserschwingung aufrechterhalten, wenn genügend Laserleistung bei der Wellenlänge $\lambda_L$ vorhanden ist. Diese optische Gegenkopplung durch die Laserleistung bei der Wellenlänge $\lambda_L$ kann bei Halbleiterlaserverstärkern Regelzeiten herab bis zu Pikosekunden erreichen. Je nachdem ob man das Licht der Wellenlänge $\lambda$ oder $\lambda_L$ als Ausgangssignal verwendet, arbeitet die Anordnung als optisch gegengekoppelter Verstärker oder als (fakultativ abstimmbarer) Wellenlängenumsetzer. Wenn die Wellenlänge $\lambda_L$ kleiner ist als die Wellenlänge $\lambda$ des eingestrahlten Lichtes, ist der optische Gewinn des gegengekoppelten Verstärkers besonders stabil bzw. ist die Wellenlängenumsetzung besonders effizient.

Durch zusätzliche Einstrahlung des Lichtes eines Lokaloszillators bei einer Wellenlänge $L_{LO}$ in der Nähe der Wellenlänge L des eingestrahlten (Signal-) Lichts kann die Effizienz der Wellenlängenumsetzung erhöht werden. Die Erhöhung der Effizienz beruht auf Signalverstärkung durch kohärente Überlagerung optischer Wellen. Wenn das Signallicht aus einer Vielzahl optischer Kanäle mit den Wellenlängen $L_1,..., L_J, ..., L_N$ besteht, kann die kohärente Signalverstärkung zur Selektion beispielsweise des J-ten Kanals mit der Wellenlänge $L_J$ benutzt werden. Die Information des J-ten Kanals steht bei der Wellenlänge $L_J''$ zur Verfügung. Durch Ansteuerung eines weiteren Wellenlängenumsetzers kann die Information auf die gewünschte Wellenlänge umgesetzt werden, insbesondere auch in den ursprünglichen Wellenlängenbereichen $L_1, ..., L_N$.

Durch ein genügend starkes Eingangssignal kann die Laserstrahlung ganz zum Verlöschen gebracht werden (Funktion als optischer Inverter). Die optische Kontrolle der Laserleistung kann auch durch mehrere Eingangssignale und unter Umständen bei verschiedenen Wellenlängen erfolgen (Funktion als optisches NOR-

EP 0 409 177 B1

Gatter). Die Abhängigkeit der Laserleistung vom Eingangssignal wird nichtlinear, wenn sich ein Medium mit optisch sättigbarer Absorption im Strahlengang bzw. im Resonator befindet. Die Nichtlinearität ist besonders ausgeprägt, wenn die elektronische Energiebandlücke des absorbierenden Mediums $E_A$ gleich oder größer ist als die elektronische Energiebandlücke $E_V$ des Verstärkungsmediums. Die Absorption ist dann vorzugsweise durch Licht bei der Wellenlänge $\lambda_L$ beeinflußbar.

Durch Einstrahlung wird die Laserleistung erniedrigt, als Folge aber auch die Absorption im Resonator erniedrigt. Durch dieses optische nichtlineare Verhalten reißt oberhalb eines bestimmten Schwellenwertes der eingestrahlten Leistung die Laserschwingung ab, so daß optische Pulsregeneration mit Signalinversion erreicht wird.

Befindet sich innerhalb des Resonators zusätzlich ein optisch sättigbarer Absorber, der vorzugsweise eine elektronische Bandlücke $E_A$ gleich oder kleiner als die elektronische Energiebandlücke $E_V$ des Verstärkungsmediums aufweist, so kann durch entsprechende Wahl der Anordnung und Betriebsweise eine optische Pulsfolge bei der Wellenlänge $\lambda_L$ erzeugt werden. Durch Einstrahlung bei der Wellenlänge $\lambda$ kann die Intensität und Wiederholrate dieser Pulsfolge beeinflußt werden.

Wird die Intensität der Laserstrahlung bei der Wellenlänge $\lambda_L$ durch die genannte optische Einstrahlung bei der Wellenlänge oder auch durch Modulation der Pumprate des Verstärkungsmediums variiert, so wird auch der Brechungsindex des Verstärkungsmediums moduliert. Diese Modulation des Brechungsindex kann zur Modulation der Phase oder Frequenz einer eingestrahlten Signalwelle benutzt werden.

In Fig. 4 ist eine erfindungsgemäße Anordnung dargestellt, bei der die für die Einkopplung des Lichtes vorgesehene Vorrichtung in einem als Faserverstärker ausgebildeten Faserleiter besteht. Ein Halbleiterlaser 2 befindet sich am Ausgang des mit Erbium dotierten Faserverstärkers 20, wobei das vom Halbleiterlaser 2 emittierte Laserlicht 12 der Wellenlänge $\lambda_L$ im Wellenlängenbereich um $\lambda$ = 1500 nm kürzer ist als die ausgezeichnete Wellenlänge $\lambda_M$ des Maximums des Gewinns des Verstärkungsmediums im Halbleiterlaser 2. Das Laserlicht 12 der Wellenlänge $\lambda_L$ kann dann zum optischen Pumpen des Faserverstärkers 20 verwendet werden. Das vom Faserverstärker 20 verstärkte Signallicht 11 der Wellenlänge $\lambda$ größer als $\lambda_L$ durchläuft den Halbleiterlaser 2 je nach Wellenlänge unter weiterer optischer Verstärkung oder auch weitgehend unverstärkt.

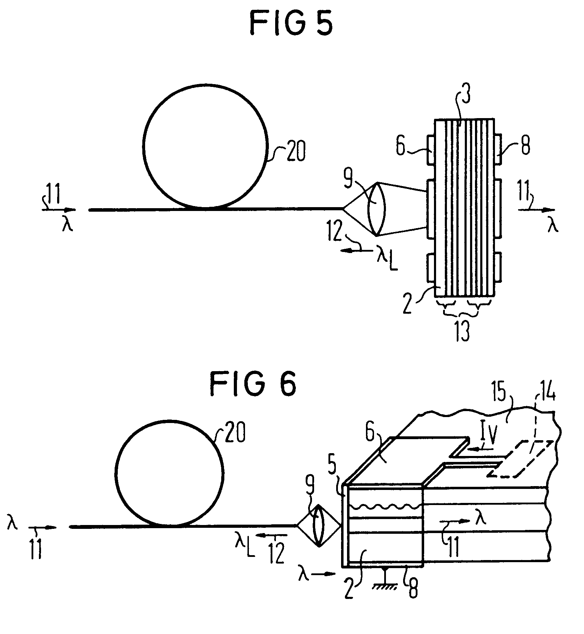

Fig. 5 zeigt eine alternative Ausgestaltung der erfindungsgemäßen Anordnung nach Fig. 4, wobei jetzt ein oberflächenemittierender Halbleiterlaser verwendet wird. Ein solcher oberflächenemittierender Halbleiterlaser ist dadurch gekennzeichnet, daß das Laserlicht der selektierten Wellenlänge $\lambda_L$ senkrecht zur Oberfläche des Substrats 2 ausgekoppelt wird, auf der die aktive Schicht des Halbleiterlasers aufgewachsen ist. Die Anordnung von Fig. 5 kombiniert in einfacher Weise die Einkopplung von Pumplicht der Wellenlänge $\lambda_L$ in den Faserver stärker 20 mit der Auskopplung von Signallicht 11 der Wellenlänge $\lambda$ aus dem Faserverstärker. Am Ausgang des Halbleiterlasers befindet sich ein Bragg-Reflektor 13 mit höherer Reflexion als am Eingang des Halbleiterlasers. Deshalb wird das Pumplicht nur in Richtung des Faserverstärkers ausgekoppelt. Am anderen Ende des Halbleiterlasers tritt nur das verstärkte Signallicht 11 aus.

Die Anordnung entsprechend Fig. 4 läßt sich in abgewandelter Form zur Regelung für Chip-Faser-Kopplung einsetzen. Gemäß Fig. 6 wird dabei ein Halbleiterlaser 2 eingesetzt, der nicht oberflächenemittierend sondern kantenemittierend ist und der Teil eines optoelektronischen integrierten Schaltkreises (OEIC) ist.

Zur optischen Signalverarbeitung auf dem OEIC 15 kann das verstärkte Signal 11 der Wellenlänge $\lambda$ über planare Wellenleiter und Verzweiger zu weiteren Bauelementen wie z.B. Modulatoren, Fotodetektoren und optischen Logikgattern geführt werden. Bei einer dementsprechenden Anordnung werden in einfacher Weise die Koppelverluste zwischen Glasfaser und OEIC durch optische Vorverstärker im Faserverstärker kompensiert.

Insbesondere kann durch den optischen Faserverstärker, gefolgt von dem Halbleiterlaser 2, dem Filter F und dem Photodetektor ein optischer Empfänger mit rauscharmen optischem Vorverstärker realisiert werden. Für diese Anordnung ist es nicht erforderlich, daß die Wellenlänge $\lambda_M$ und $\lambda_L$ verschieden sind, so daß die Differenz zwischen dem Schwellengewinn des Resonators und dem Gewinn des Verstärkungsmediums im Verstärkerbetrieb bei der selektierten Wellenlänge $\lambda_L$ und der ausgezeichneten Wellenlänge $\lambda_M$ gleich ist.

Bei einer derartigen Anordnung kann eine aktiv geregelte Verstärkung des Signallichtes vorgesehen sein. Im Regelbaustein 14 wird ein Teil der spontanen Emission des Halbleiterlasers 2 oder ein Teil des verstärkten Signallichtes detektiert und hieraus ein Stellstrom $I_V$ für den Halbleiterlaser abgeleitet. Durch diese Regelung kann der OEIC bei definierten Pegeln des Signallichtes arbeiten, unabhängig von Schwankungen im Ankopplungsgrad der Faser und unabhängig von Schwankungen des Pegels des Signallichtes in der Faser. Wird auf das Bragg-Gitter im Halbleiterlaser verzichtet, so ergibt sich ein Wanderwellenverstärker auf Halbleiterbasis. Die Regelung des Pegels des Signallichtes kann dann auch mit einer Glasfaser ohne optische Verstärkung realisiert werden.

Figur 8 zeigt das Blockschaltbild eines Wellenlängenschalters unter Verwendung der erfindungsgemäßen Aufbauten mit N wellenlängenselektiven Wellenlängenumsetzern (mit Wellenlinien bezeichnet) und N abstimmbaren Wellenlängenumsetzern (mit Pfeilen bezeichnet). Im Gegensatz zu herkömmlichen Anordnungen (s. z.B. E.J. Bachus et al.: "Optical Coherent Multicarrier Switching Experiment, IOOC'89, Japan, 1989, paper 20D2-2) erfolgt das Schalten optischer Kanäle bei dem erfindungsgemäßen Aufbau durch mehrfache optische Wellenlängenumsetzung, wodurch eventuell optische Filter oder elektronische Zwischenstufen eingespart werden können. Bei der eingezeichneten Anordnung werden N Kanäle in einem Wellenlängenband, das die Wellenlängen $L_1,..., L_N$ enthält, umgesetzt in ein zweites Wellenlängenband, das die Wellenlängen $L''_1, ..., L''_N$ enthält, und anschließend erneut umgesetzt in ein drittes Wellenlängenband, das die Wellenlänge $L'''_1,...L'''_N$ enthält. Das erste Wellenlängenband und das dritte Wellenlängenband können auch gleich sein. In diesem Fall werden z.B. wie in Figur 8 eingezeichnet die Wellenlängen $L''_1,...,L''_N$ des zweiten Wellenlängenbandes in eine Permutation der ursprünglichen Wellenlängen $L_1,..., L_N$ im ersten Wellenlängenband zurücktransformiert. Das Wellenlängenband der Wellenlängen $L_1$ bis $L_N$ ist höher, d.h. diese Wellenlängen sind länger, als das Wellenlängenband für die Wellenlängen $L_1'$ bis $L_N'$. Die Information für das Schema der Permutation der optischen Kanäle kann z.B. durch optische Signale an den Wellenlängenschalter herangeführt werden. In dem vorliegenden Beispiel bestehen die wellenlängenselektiven Wellenlängenumsetzer (mit Wellenlinie eingezeichnet) jeweils aus einem elektronisch abstimmbaren Lokaloszillator, gefolgt von einem optischen Phasenschieber, einem optischen Polarisationsdreher und einem erfindungsgemäßen Wellenlängenumsetzer. Diese erfindungsgemäßen Wellenlängenumsetzer haben als Wellenlängefilter ein Gitter zweiter Ordnung, das eine um 90° räumlich gedrehte Emission der transformierten Wellenlänge bewirkt. Die Selektion der zu transformierenden Wellenlänge erfolgt wie oben beschrieben durch zusätzliche Einstrahlung einer nicht modulierten Strahlung einer Wellenlänge, die der zu selektierenden Wellenlänge zumindest näherungsweise entspricht. D er erfindungsgemäße Wellenlängenumsetzer emittiert das auf der selektierten Wellenlänge aufmodulierte Signal auf einer neuen Wellenlänge, die durch das in dem betreffenden Wellenlängenumsetzer eingebaute Gitter bestimmt ist. In der Zeichnung sind die eingestrahlten Wellenlängen mit $L_1$ bis $L_N$ bezeichnet. In den ersten selektiven Wellenlängenumsetzer wird eine nicht modulierte Strahlung der Wellenlänge $L'_1$ eingestrahlt, die einer der Wellenlängen $L_1$ bis $L_N$, z.B. $L_k$, zumindest näherungsweise entspricht. Die übrigen Wellenlängen passieren den Wellenlängenumsetzer praktisch unbehindert (in der Fig. 8 nach rechts gerichteter Pfeil). Senkrecht zu dieser Strahlrichtung wird eine Wellenlänge $L''_1$, die mit dem ursprünglich auf $L_k$ aufmodulierten Signal moduliert ist, abgestrahlt. Diese Wellenlänge $L''_1$ wird in einem elektronisch abstimmbaren erfindungsgemäßen Wellenlängenumsetzer z.B. in eine der ursprünglichen Wellenlängen $L_1$ bis $L_N$ transformiert. Das entsprechende geschieht mit den übrigen Wellenlängen in jeweils dafür vorgesehenen Paaren von wellenlängenselektiven und abstimmbaren Wellenlängenumsetzern. Man erhält auf diese Weise am Ausgang der Anordnung eine Überlagerung z.B. der ursprünglichen Trägerfrequenzen $L_1$ bis $L_N$, wobei jetzt die jeweiligen Modulationen in einer anderen Permutation auf diese Trägerwellenlängen verteilt sind. In Fig. 8 ist mit den Indices $\pi 1, ..., \pi N$ eine Permutation der Zahlen 1 bis N bezeichnet.

## Patentansprüche

1. Anordnung mit einem Halbleiterlaser (2), der mindestens ein Wellenlängenfilter, mindestens ein optisches Verstärkungsmedium und einen Resonator aufweist, wobei ein erstes Wellenlängenfilter eine für den Laserbetrieb vorgesehene Wellenlänge ($\lambda_L$) selektiert und wobei das Verstärkungsmedium eine ausgezeichnete Wellenlänge ($\lambda_M$) aufweist, bei der der Gewinn des Verstärkungsmediums bei Laserbetrieb maximal ist,
   **dadurch gekennzeichnet,**
   daß das Wellenlängenfilter (4) so ausgebildet ist, daß die Differenz zwischen dem Schwellengewinn ($G_t$) des Resonators und dem Gewinn des Verstärkungsmediums ($G_m$) im Laserbetrieb bei der selektierten Wellenlänge ($\lambda_L$) kleiner ist als bei der ausgezeichneten Wellenlänge ($\lambda_M$) und
   daß eine Vorrichtung (1,10) zur optischen Einstrahlung bei mindestens einer Wellenlänge $\lambda$ in das Verstärkungsmedium vorhanden ist.

2. Anordnung nach Anspruch 1,
   **dadurch gekennzeichnet,**
   daß das Wellenlängenfilter ein Gitter (4) ist.

3. Anordnung nach Anspruch 1 oder 2,
   **dadurch gekennzeichnet,**
   daß der Halbleiterlaser einen Wellenleiter (3) als integrierten Bestandteil aufweist und
   daß die Vorrichtung zur optischen Einstrahlung ein an diesen Wellenleiter (3) angekoppelter externer Wellenleiter ist.

4. Anordnung nach Anspruch 3,
**dadurch gekennzeichnet,**
daß der externe Wellenleiter ein Faserleiter ist.

5. Anordnung nach einem der Ansprüche 1 bis 4,
**dadurch gekennzeichnet,**
daß vorhandene Resonatorendflächen des Halbleiterlasers (2) mit Entspiegelungsschichten (5) versehen sind.

6. Anordnung nach einem der Ansprüche 1 bis 5,
**dadurch gekennzeichnet,**
daß eine Vorrichtung zur Auskopplung von Strahlung aus dem Halbleiterlaser (2) vorhanden ist.

7. Anordnung nach einem der Ansprüche 1 bis 6,
**dadurch gekennzeichnet,**
daß der Halbleiterlaser (2) einen optisch sättigbaren Absorber enthält.

8. Anordnung nach einem der Ansprüche 1 bis 7,
**dadurch gekennzeichnet,**
daß die selektierte Wellenlänge ($\lambda_L$) um mindestens soviel von der ausgezeichneten Wellenlänge ($\lambda_M$) verschieden ist, daß für die ausgezeichnete Wellenlänge ($\lambda_M$) das Wellenlängerfilter durchlässig ist.

9. Anordnung nach einem der Ansprüche 1 bis 7,
**dadurch gekennzeichnet,**
daß die eingestrahlte Wellenlänge $\lambda$ außerhalb des Wellenlängenbereichs um die selektierte Wellenlänge ($\lambda_L$) ist,
in dem das Wellenlängenfilter im wesentlichen reflektierend ist.

10. Anwendung der Anordnung nach einem der Ansprüche 1 bis 9 als optisch gegengekoppelter Verstärker, wobei die Stärke des angelegten Betriebsstromes ($I_V$) so eingestellt wird, daß der Halbleiterlaser (2) bei der selektierten Wellenlänge ($\lambda_L$) strahlt,
und wobei das eingestrahlte Licht eine Wellenlänge aufweist, bei der das Wellenlängenfilter durchlässig ist.

11. Anwendung einer Anordnung nach einem der Ansprüche 1 bis 9, als optisch gegengekoppelter Verstärker entsprechend Anspruch 10,
**dadurch gekennzeichnet,**
daß die Wellenlänge des eingestrahlten Lichtes etwa der ausgezeichneten Wellenlänge ($\lambda_M$) entspricht.

12. Anwendung einer Anordnung nach einem der Ansprüche 1 bis 9, als abstimmbarer optischer Wellenlängenumsetzer, wobei die selektierte Wellenlänge ($\lambda_L$) als Ausgangssignal verwendet wird.

13. Anwendung einer Anordnung nach einem der Ansprüche 1 bis 9, als optisches Logikgatter, wobei die eingestrahlte Lichtstärke so erhöht wird, daß die Laserstrahlung der selektierten Wellenlänge ($\lambda_L$) ganz ausgelöscht wird.

14. Anwendung einer Anordnung nach einem der Ansprüche 1 bis 9 als optischer Pulsregenerator.

15. Anwendung einer Anordnung nach Anspruch 7 als optisch kontrollierbarer Pulsgenerator.

16. Anwendung einer Anordnung nach einem der Ansprüche 1 bis 9 als Phasenmodulator durch Änderung des Brechungsindexes des Verstärkungsmediums mittels einer Änderung der elektrischen Pumprate und einer Änderung der Intensität der optischen Einstrahlung.

17. Anwendung einer Anordnung nach Anspruch 4, wobei der Faserleiter ein mit Erbium dotierter Faserverstärker ist und wobei die von dem Halbleiterlaser (2) emittierte Strahlung der selektierten Wellenlänge ($\lambda_L$) zum optischen Pumpen dieses Faserverstärkers verwendet wird.

18. Anordnung mit mindestens einem Paar von Wellenlängenumsetzern, von denen mindestens ein Wellenlängenumsetzer eine Anordnung nach Anspruch 1 ist, zum Betrieb als Wellenlängenschalter, bei dem aus einer Überlagerung mehrerer zu einem ersten Wellenlängenband gehörender Wellenlängen mit aufmodulierten Signalen jeweils in der ersten Anordnung eines solchen Paares eine Wellenlänge selektiert, das darauf aufmodulierte Signal einer neuen Wellenlänge aus einem zu dem ersten disjunkten zweiten Wellenlängenband aufmoduliert wird und in der zweiten Anordnung dieses Paares diese neue Wellenlänge in eine Wellenlänge eines dritten Wellenlängenbandes transformiert wird.

19. Anordnung mit einem Paar von Wellenlängenumsetzern, von denen mindestens ein Wellenlängenumsetzer eine Anordnung nach Anspruch 1 ist, zum Betrieb als Wellenlängenschalter, bei dem eine zu einem Wellenlängenband gehörende Wellenlänge in der ersten Anordnung dieses Paares in eine Wellenlänge außerhalb dieses Wellenlängenbandes transformiert wird und anschließend in der zweiten Anordnung dieses Paares in eine Wellenlänge innerhalb des Wellenlängenbandes transformiert wird.

20. Anordnung nach Anspruch 4, bei der der Faserleiter ein Faserverstärker zur Verstärkung der eingestrahlten Wellenlänge $\lambda$ ist, wobei der Halbleiterlaser Pumplicht der selektierten Wellenlänge ($\lambda_L$) in den Faserverstärker emittiert und wobei die eingestrahlte Wellenlänge $\lambda$ diesen Halbleiterlaser durchläuft.

## Claims

1. Arrangement having a semiconductor laser (2), which exhibits at least one wavelength filter, at least one optical amplification medium and a resonator, a first wavelength filter selecting a wavelength ($\lambda_L$) intended for laser operation and the amplification medium exhibiting a particular wavelength ($\lambda_M$) at which the gain of the amplification medium in laser operation is a maximum, characterized in that the wavelength filter (4) is designed so that the difference between the threshold gain ($G_t$) of the resonator and the gain of the amplification medium ($G_m$) in laser operation is smaller at the selected wavelength ($\lambda_L$) than at the particular wavelength ($\lambda_M$), and in that a device (1, 10) is provided for optical incident radiation at at least one wavelength $\lambda$ into the amplification medium.

2. Arrangement according to Claim 1, characterized in that the wavelength filter is a grating (4).

3. Arrangement according to Claim 1 or 2, characterized in that the semiconductor laser exhibits a waveguide (3) as integrated component, and in that the device for optical incident radiation is an external waveguide coupled to this waveguide (3).

4. Arrangement according to Claim 3, characterized in that the external waveguide is a fibre guide.

5. Arrangement according to one of Claims 1 to 4, characterized in that existing resonator end surfaces of the semiconductor laser (2) are provided with antireflection coatings (5).

6. Arrangement according to one of Claims 1 to 5, characterized in that a device is provided for emitting radiation from the semiconductor laser (2).

7. Arrangement according to one of Claims 1 to 6, characterized in that the semiconductor laser (2) includes an optically saturable absorber.

8. Arrangement according to one of Claims 1 to 7, characterized in that the selected wavelength ($\lambda_L$) differs from the particular wavelength ($\lambda_M$) by at least an amount such that the wavelength filter is transmissive for the particular wavelength ($\lambda_M$).

9. Arrangement according to one of Claims 1 to 7, characterized in that the incident radiation wavelength $\lambda$ is outside the wavelength range, around the selected wavelength ($\lambda_L$), in which the wavelength filter is substantially reflective.

10. Use of the arrangement according to one of Claims 1 to 9 as an optical-feedback amplifier, the strength of the applied operating current ($I_v$) being set so that the semiconductor laser (2) radiates at the selected wavelength ($\lambda_L$), and the incident radiation light exhibiting a wavelength at which the wavelength filter is transmissive.

11. Use of an arrangement according to one of Claims 1 to 9 as an optical-feedback amplifier according to Claim 10, characterized in that the wavelength of the incident radiated light corresponds approximately to the particular wavelength ($\lambda_M$).

12. Use of an arrangement according to one of Claims 1 to 9 as a tunable optical wavelength converter, the selected wavelength ($\lambda_L$) being used as output signal.

13. Use of an arrangement according to one of Claims 1 to 9 as an optical logic gate, the incident radiated light intensity being increased so that the laser radiation at the selected wavelength ($\lambda_L$) is entirely extinguished.

14. Use of an arrangement according to one of Claims 1 to 9 as an optical pulse regenerator.

15. Use of an arrangement according to Claim 7 as an optically controllable pulse generator.

16. Use of an arrangement according to one of Claims 1 to 9 as a phase modulator by alteration of the refractive index of the amplification medium by means of an alteration of the electrical pump rate and an alteration of the intensity of the optical incident radiation.

17. Use of an arrangement according to Claim 4, the fibre guide being a fibre amplifier doped with erbium, and the radiation at the selected wavelength ($\lambda_L$) which is emitted by the semiconductor laser (2) being used for the optical pumping of this fibre amplifier.

18. Arrangement having at least one pair of wavelength converters, of which at least one wavelength converter is an arrangement according to Claim 1, for operation as a wavelength switch, in which a wavelength is selected in each case in the first arrangement of such a pair from a superposition of a plurality of wavelengths belonging to a first wavelength band with signals modulated thereon, the signal modulated thereon is modulated at a new wavelength from a second wavelength band which is disjunctive with the first and this new wavelength is transformed, the second arrangement of this pair, into a wavelength of a third wavelength band.

19. Arrangement having a pair of wavelength converters, of which at least one wavelength converter is an arrangement according to Claim 1, for operation as a wavelength switch, in which a wavelength belonging to a wavelength band is transformed into a wavelength outside this wavelength band in the first arrangement of this pair, and is subsequently transformed in the second arrangement of this pair into a wavelength within the wavelength band.

20. Arrangement according to Claim 4, in which the fibre guide is a fibre amplifier for amplifying the incident radiated wavelength $\lambda$, the semiconductor laser emitting pump light at the selected wavelength ($\lambda_L$) into the fibre amplifier, and the incident radiated wavelength $\lambda$ passing through this semiconductor laser.

**Revendications**

1. Dispositif comportant un laser à semiconducteurs (2), qui possède au moins un filtre des longueurs d'onde, au moins un milieu optique amplificateur et un résonateur, et dans lequel un premier filtre des longueurs d'onde sélectionne une longueur d'onde ($\lambda_L$) prévue pour le fonctionnement laser, et le milieu amplificateur possède une longueur d'onde remarquable ($\lambda_M$), pour laquelle le gain du milieu amplificateur pour le fonctionnement laser est maximum, caractérisé par le fait
que le filtre des longueurs d'onde (4) est agencé de telle sorte que la différence entre le gain seuil (G) du résonateur et le gain du milieu amplificateur ($G_m$) pendant le fonctionnement laser est plus faible pour la longueur d'onde sélectionnée ($\lambda_L$) que pour la longueur d'onde remarquable ($\lambda_M$), et
qu'il est prévu un dispositif (1, 10) pour réaliser une irradiation optique dans le milieu amplificateur pour au moins une longueur d'onde ($\lambda$).

2. Dispositif suivant la revendication 1, caractérisé par le fait que le filtre des longueurs d'onde est un réseau (4).

3. Dispositif suivant la revendication 1 ou 2, caractérisé par le fait

que le laser à semiconducteurs possède un guide d'ondes (3) réalisé sous la forme d'un composant intégré, et

que le dispositif d'irradiation optique est un guide d'ondes externe, couplé à ce guide d'ondes (3).

4. Dispositif suivant la revendication 3, caractérisé par le fait que le guide d'ondes externe est un conducteur formé d'une fibre.

5. Dispositif suivant l'une des revendications 1 à 4, caractérisé par le fait que les surfaces d'extrémité présentes du résonateur du laser à semiconducteurs (2) comportent des couches antireflet (5).

6. Dispositif suivant l'une des revendications 1 à 5, caractérisé par le fait qu'il est prévu un dispositif pour découpler le rayonnement sortant du laser à semiconducteurs (2).

7. Dispositif suivant l'une des revendications 1 à 6, caractérisé par le fait que le laser à semiconducteurs (2) comporte un dispositif d'absorption pouvant être saturé optiquement.

8. Dispositif suivant l'une des revendications 1 à 7, caractérisé par le fait que la longueur d'onde sélectionnée ($\lambda_L$) diffère de la longueur d'onde remarquable ($\lambda_M$) au moins à un point tel que le filtre des longueurs d'onde transmet la longueur d'onde remarquable ($\lambda_M$).

9. Dispositif suivant l'une des revendications 1 à 7, caractérisé par le fait que la longueur d'onde introduite ($\lambda$) se situe à l'extérieur de la gamme des longueurs d'onde entourant la longueur d'onde sélectionnée ($\lambda_L$), dans laquelle le filtre des longueurs d'onde est essentiellement réfléchissant.

10. Mise en oeuvre du dispositif suivant l'une des revendications 1 à 9 en tant qu'amplificateur couplé par un couplage à contre-réaction optique, pour laquelle l'intensité du courant de service appliqué ($I_V$) est réglée de telle sorte que le laser à semiconducteurs (2) émet pour la longueur d'onde sélectionnée ($\lambda_L$), et pour laquelle la lumière introduite possède une longueur d'onde pour laquelle le filtre des longueurs d'onde est transmissif.

11. Mise en oeuvre d'un dispositif suivant l'une des revendications 1 à 9, en tant qu'amplificateur couplé avec une contre-réaction optique suivant la revendication 10, caractérisée par le fait que la longueur d'onde de la lumière introduite correspond approximativement à la longueur d'onde remarquable ($\lambda_M$).

12. Mise en oeuvre d'un dispositif suivant l'une des revendications 1 à 9, en tant que convertisseur optique accordable de longueurs d'onde, la longueur d'onde sélectionnée ($\lambda_L$) étant utilisée en tant que signal de sortie.

13. Mise en oeuvre d'un dispositif suivant l'une des revendications 1 à 9 en tant que porte logique optique, et pour laquelle l'intensité lumineuse introduite est accrue de manière que le rayonnement laser possédant la longueur d'onde sélectionnée ($\lambda_L$) soit complètement éliminé.

14. Mise en oeuvre d'un dispositif suivant l'une des revendications 1 à 9 en tant que générateur optique d'impulsions.

15. Mise en oeuvre d'un dispositif suivant la revendication 7 en tant que générateur d'impulsions pouvant être contrôlé optiquement.

16. Mise en oeuvre d'un dispositif suivant l'une des revendications 1 à 9 en tant que modulateur de phase par modification de l'indice de réfraction du milieu amplificateur au moyen d'une modification de la cadence de pompage électrique et d'une modification de l'intensité du rayonnement optique introduit.

17. Mise en oeuvre d'un dispositif suivant la revendication 4, pour laquelle le conducteur à fibre est un amplificateur à fibre dopé par de l'erbium, et pour laquelle le rayonnement émis par le laser à semiconducteurs (2) et qui possède la longueur d'onde sélectionnée ($\lambda_L$) est utilisé pour le pompage optique de cet amplificateur à fibre.

18. Dispositif comportant au moins un couple de convertisseurs de longueurs d'onde, dont l'un au moins est un dispositif suivant la revendication 1, pour le fonctionnement en tant qu'interrupteur de longueurs d'onde, dans lequel une longueur d'onde est sélectionnée à partir d'une superposition de plusieurs longueurs d'onde faisant partie d'une première bande de longueurs d'onde, avec des signaux de modulation, respectivement dans le premier dispositif d'un tel couple, le signal modulant ladite longueur d'onde est émis avec une nouvelle longueur d'onde faisant partie d'une seconde bande de longueurs d'onde différente de la première bande de longueurs d'onde, et, dans le second dispositif de ce couple, cette nouvelle longueur d'onde est transformée en une longueur d'onde faisant partie d'une troisième bande de longueurs d'onde.

19. Dispositif comportant un couple de convertisseurs de longueurs d'onde, dont l'un au moins est un dispositif suivant la revendication 1, pour le fonctionnement en tant qu'interrupteur de longueurs d'onde, dans lequel une longueur d'onde, qui fait partie d'une bande de longueurs d'onde, est transformée dans le premier dispositif de ce couple en une longueur d'onde située à l'extérieur de cette bande de longueurs d'onde et ensuite est transformée, dans le second dispositif de ce couple, en une longueur d'onde située à l'intérieur de la bande des longueurs d'onde.

20. Dispositif suivant la revendication 4, dans lequel le conducteur à fibre est un amplificateur à fibre servant à amplifier la longueur d'onde ($\lambda$) introduite, le laser à semiconducteurs émettant la lumière de pompage possédant la longueur d'onde sélectionnée ($\lambda_L$) dans l'amplificateur à fibre, tandis que la longueur d'onde ($\lambda$) introduite traverse ce laser à semiconducteurs.

# FIG 1

FIG 2

FIG 3

FIG 4

# FIG 5

# FIG 6

# FIG 7

# FIG 8